# EUROPEAN PATENT SPECIFICATION

(11) **EP 3 911 133 B1**
(45) Date of publication and mention of the grant of the patent: **02.04.2025**
(21) Application number: 18943584.5
(22) Date of filing: 20.12.2018
(51) Int. Cl.: H05K 5/00, H05K 5/06, H05K 5/02

(54) **CONTROLLER FOR LIFTING PLATFORM AND LIFTING PLATFORM**
STEUERUNG FÜR EINE HEBEBÜHNE UND HEBEBÜHNE
DISPOSITIF DE COMMANDE POUR PLATE-FORME DE LEVAGE ET PLATE-FORME DE LEVAGE

(43) Date of publication of application: 17.11.2021
(73) Proprietor: Zhejiang Jiecang Linear Motion Technology Co., Ltd, Shaoxing, Zhejiang 312500 (CN)
(72) Inventor: DING, Miaojiang, Shaoxing, Zhejiang 312500 (CN); MA, Yong, Shaoxing, Zhejiang 312500 (CN)
(74) Representative: karo IP
(86) International application number: PCT/CN2018/122212
(87) International publication number: WO 2020/124464

(56) References cited:
- EP-A2- 0 911 752
- EP-A2- 2 159 131
- CN-U- 202 818 824
- CN-U- 202 818 824
- CN-U- 204 302 694
- CN-U- 204 305 505
- CN-U- 204 305 505
- CN-U- 204 951 800
- CN-U- 206 137 515
- CN-U- 206 137 515
- JP-A- 2010 057 345
- US-A1- 2005 167 183

## Description

### FIELD

Embodiments of the present disclosure relate to controllers, and more particularly relate to a controller for a lifting platform, and a lifting platform.

### BACKGROUND

A conventional lifting platform generally leverages a controller to control actuators to bring a lifting column to lift and lower, where the controller and the actuators are connected via wires. A controller for a lifting platform is disclosed in CN 204 305 505 U and CN 206 137 515 U. JP 2010 057345 A discloses another controller. To optimize wire length, a lateral side of the controller is usually arranged with an opening for the wires to access, a consequence of which is that the wires, when being stressed, easily fall off the controller, causing disconnection between the controller and the actuators and rendering the controller unreliable in use.

### SUMMARY

Embodiments of the present disclosure provide a lifting platform with a controller for the lifting platform , which are reliable in use.

The present disclosure adopts the following technical solutions: a controller for a lifting platform, the lifting platform including a lateral beam and actuators, two actuators being provided and respectively disposed at two ends of the lateral beam, wherein the controller comprises a control box and a circuit board provided in the control box, the circuit board being connected with the actuators via wires, the backside of the control box being connected to the lateral bean, wherein openings facilitating connection between the wire and the circuit board are arranged on the control box, at least one opening being provided at the frontside of the control box.

Furthermore, the circuit board and the actuators are connected via the wire, and terminals for connecting with the wire are provided on the circuit board, the terminals being exposed via the openings.

Furthermore, the control box includes a base plate and a box body, and the control box is insert-fitted onto the lateral beam via the base plate.

Furthermore, a snap-fit is provided on the lateral beam, and a slot fitted with the snap-fit is provided on the base plate.

Furthermore, the slot is positioned on a lateral side of the base plate; or, the slot is disposed on a side of the base plate facing the lateral beam.

Furthermore, the snap-fit and the lateral beam are integrally arranged; or, the snap-fit and the lateral beam are separately arranged.

Furthermore, a slot is arranged on the lateral beam, and a snap-fit fitted with the slot is arranged on the base plate.

Furthermore, the snap-fit is arranged on a lateral side of the base plate; or, the snap-fit is positioned on the side of the base plate facing the lateral beam.

The present disclosure further provides a lifting platform, comprising: a top, a lateral beam and a lifting column, which are supported underneath the top, an actuator for driving lifting and lowering of the lifting platform, and a controller disposed on the lateral beam, wherein the controller refers to the controller in any of the above technical solutions.

In the present disclosure, the controller box is mounted on the lateral beam and arranged to face downward; the "backside of the controller" refers to the side of the control box facing the lateral beam, and the "frontside of the control box" refers to the side of the control box facing the ground.

With the above technical solutions, the present disclosure offers the following advantages:
1. In use, the actuators are disposed at the left and right sides of the control box. If the openings are arranged at the left and right sides of the control box, the wires between the actuators and the control box are easily pulled apart from the circuit board and thus falls off the control box, causing electrical disconnection between the actuators and the controller. In the present disclosure, at least one opening is disposed at the frontside of the control box, such that the actuators are not easily disengaged from the circuit board, rendering a more reliable connection between the control box and the actuators, further rendering the controller more reliable in use.
2. The wires are connected to the circuit board via terminals, wherein the terminals are exposed via the openings, such that the wires are insert-fitted with the terminals to realize connection with the circuit board, rendering wire connection simple and reliable.
3. The control box is insert-fitted onto the lateral beam via the base plate, rendering a simple and convenient connection between the controller and the lateral beam.
4. By providing a snap-fit on the lateral beam and providing a slot on the base plate, or by providing a slot on the lateral beam and providing a snap-fit on the base plate, fitting between the snap-fit and the slot implements connection between the base plate and the lateral beam.
5. The present disclosure further provides a lifting platform, wherein the controller of the lifting platform refers to the controller described above, rendering a reliable connection between the controller and the actuators, further rendering the lifting platform reliable in use.

### BRIEF DESCRIPTION OF THE SEVERAL VIEWS OF THE DRAWINGS

Hereinafter, the present disclosure will be described in further detail with reference to the accompanying drawings:
Fig. 1 is a schematic view of fitting between the opening a and the wire in a controller according to a first embodiment of the present disclosure.
Fig. 2 is a structural schematic view of the controller according to the first embodiment of the present disclosure.
Fig. 3 is a structural schematic view from another direction of the controller according to the first embodiment of the present disclosure.
Fig. 4 is a structural schematic diagram of the controller according to a second embodiment of the present disclosure.
Fig. 5 is a structural schematic view of a base plate in the controller according to a third embodiment of the present disclosure.
Fig. 6 is a structural schematic view of a base plate in the controller according to a fourth embodiment of the present disclosure.
Fig. 7 is a structural schematic diagram of a controller according to a fifth embodiment of the present disclosure.

### Reference Numerals:

1. control box; 11. base plate; 12. box body; 121. opening; 2. snap-fit; 21. limit notch; 3. slot; 31. stop block; 4. wire.

### DETAILED DESCRIPTION

Hereinafter, the present disclosure will be described in further detail through preferred embodiments with reference to the accompanying drawings. It is understood that the terms such as "upper," "lower," "left," "right," "longitudinal," "transverse," "inner," "outer," "vertical," "horizontal," "top," "bottom," etc. only indicate the orientational or positional relationships based on the drawings, which are intended only for facilitating or simplifying description of the present disclosure, not for indicating or implying that the devices/elements must possess those specific orientations or must be configured and operated with those specific orientations; therefore, they should not be understood as limitations to the present disclosure.

### First Embodiment:

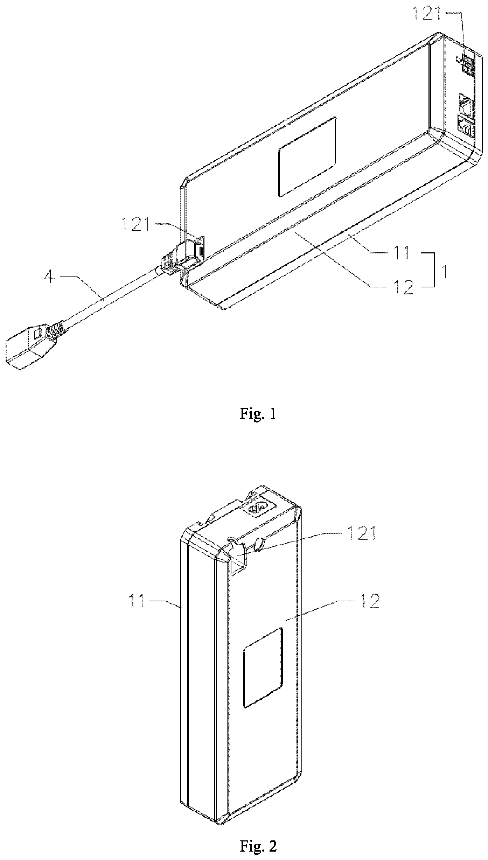

As illustrated in Figs. 1~3, the present disclosure provides a controller for a lifting platform, the lifting platform including a lateral beam and actuators, two actuators being provided and respectively disposed at two ends of the lateral beam, wherein the controller comprises a control box 1 and a circuit board provided in the control box 1, the control box 1 being arranged to face downward, the backside of the control box 1, i.e., the side of the control box facing the lateral beam, being connected to the lateral beam; terminals being provided on the circuit board; the circuit board being connected with the two actuators via two wires 4, respectively; two openings 121 being arranged on the control box 1, the terminals being exposed via the openings; the two openings being arranged for the two wires to pass through so as to connect with the terminals, wherein one opening is provided at the frontside of the control box, i.e., the side facing the ground, and the other opening is provided on a lateral side of the control box, such that in use, because the two wires are disposed on the left and right sides of the control box, respectively, the wires, when being pulled, are not easily disengaged from the circuit board, rendering a more reliable connection between the control box and the actuators, and further rendering the controller more reliable in use.

The control box 1 comprises a base plate 11 and a box body 12, wherein the control box is insert-fitted onto the lateral beam via the base plate, rendering mounting of the control box simpler and more convenient. A snap-fit is provided on the lateral beam; and a slot 3 fitted with the snap-fit is provided on the base plate 11, wherein the slot is arranged at the side of the base plate facing the lateral beam, and the snap-fit and the lateral beam are integrally arranged.

Specifically, the slot 3 refers to an inverted L- shaped slot, and the snap-fit refers to an L-shaped snap-fit; the snap-fit and the slot are interference-fitted during assembly, such that once being assembled, the fitting between the slot and the snap-fit is not easily disengaged, rendering a more reliable connection between the slot and the snap-fit, and the control box does not easily fall off the lateral beam.

Two L-shaped snap-fits are provided, and four inverted L-shaped slots are provided, wherein the four slots are arranged in a pairwise symmetrical manner, such that the slots for fitting the snap-fits are flexibly selected, and thus the position of the control box on the lateral beam is also flexibly selected.

The present disclosure further provides a lifting platform, comprising: a top, a lateral beam and a lifting column, which are supported underneath the top, actuators for driving lifting and lowering of the lifting platform, and a controller disposed on the lateral beam, wherein the controller refers to the controller as described in any of the above technical solutions. Because the connection between the controller and the actuators is more reliable and the connection between the control box and the lateral beam is simpler and more reliable, the lifting platform is also more reliable to use.

It is understood that the slots may also have an inverted "T" shape, and the snap-fits have a "T" shape.

It is understood that it is alternative to arrange only one slot.

It is understood that it is alternative to arrange two slots.

### Second Embodiment

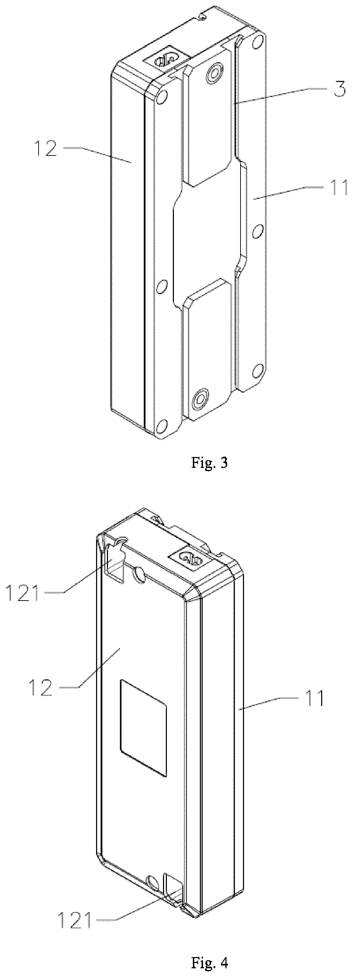

As illustrated in Fig. 4, this embodiment differs from First Embodiment mainly in that the two openings 121 are both provided on the frontside of the control box 1, which offers an advantage of providing a more reliable connection between the two wires and the circuit board, thereby further improving reliability of the controller in use.

### Third Embodiment

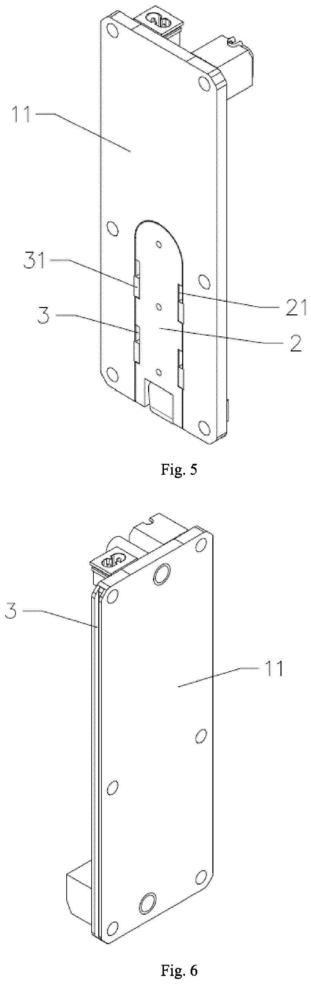

As illustrated in Fig. 5, this embodiment differs from Second Embodiment mainly in that the snap-fit 2 and the lateral beam are separately arranged, which offers an advantage that the snap-fit may be manufactured integrally with the slot, without a need to machine a snap-fit on the lateral beam, thereby simplifying the manufacturing process of the lateral beam and saving manufacturing costs.

In this embodiment, the slot 3 is a U-shaped slot, and the snap-fit 2 is a U-shaped snap-fit; a stop block 31 is provided on a wall of the slot 3, and a limit notch 21 is provided on a sidewall of the snap-fit 2; the snap-fit 2 is inserted into the slot 3 such that the stop block 31 and the limit notch 21 are fitted to fix the position of the snap-fit.

The snap-fit is in threaded connection with the lateral beam; in use, the snap-fit is removed from the slot and secured to the lateral beam via a bolt, and then the control box is secured to the lateral beam by fitting between the slot and the snap-fit.

It is understood that the slot may also have a square shape, and the snap-fit may also have a square shape.

### Fourth Embodiment:

As illustrated in Fig. 6, this embodiment differs from Second Embodiment mainly in that the slot 3 is disposed on a lateral side of the base plate 11. The slot 3 is arranged lengthwise along the base plate, such that the fitting length between the slot and the snap-fit is provided as long as possible to render a more reliable fitting; meanwhile, the vertical position of the control box is limited by the upper and lower end faces of the slot; in this way, the slot is machined in a relatively simple manner.

### Fifth Embodiment:

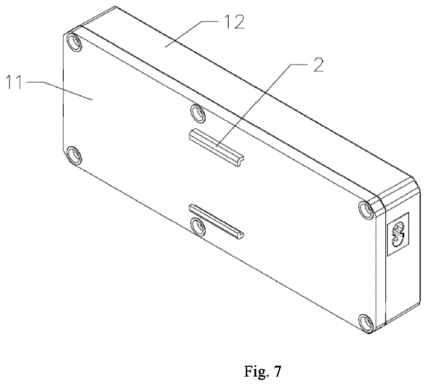

As illustrated in Fig. 7, this embodiment differs from Second Embodiment mainly in that the slot is provided on the lateral beam, and a snap-fit 2 fitted with the slot is provided on the base plate.

The slot is provided on the lateral beam; the snap-fit 2 fitted with the slot is provided on the base plate 11; specifically, the snap-fit is arranged on the side of the base plate facing the lateral beam. The snap-fit is an L-shaped snap-fit, wherein two snap-fits are arranged to achieve a more secure fitting between the snap-fit and the slot.

It is understood that the snap-fit may also be arranged on a lateral side of the base plate.

Besides the preferred embodiments above, the present disclosure further has other embodiments. Those skilled in the art may make various alterations and transformations based on the present disclosure, which should all fall into the scope defined by the appended claims of the present disclosure without departing from the spirit of the present disclosure.

## Claims

1. A lifting platform, comprising: a top, a lateral beam and a lifting column, which are supported underneath the top, actuators for driving lifting and lowering of the lifting platform, and a controller, the lifting platform including a lateral beam and actuators, two actuators being provided and respectively disposed at two ends of the lateral beam, wherein:
the controller comprises a control box (1) and a circuit board provided in the control box (1), the circuit board being connected with the actuators via wires, the backside of the control box being connected to the lateral bean, wherein openings (121) facilitating connection between the wire (4) and the circuit board are arranged on the control box (1), at least one opening (121) being provided at the frontside of the control box (1),
wherein the control box (1) includes a base plate (11) and a box body (12), and the control box (1) is insert-fitted onto the lateral beam via the base plate (11), wherein a snap-fit (2) is provided on the lateral beam, and a slot fitted with the snap-fit (2) is provided on the base plate (11), wherein the slot is arranged on the lateral beam, and a snap-fit (2) fitted with the slot is arranged on the base plate (11).

2. The lifting platform according to claim 1, wherein terminals for connecting with the wires are provided on the circuit board, the terminals being exposed via the openings (121).

3. The lifting platform according to claim 1, wherein the slot is positioned on a lateral side of the base plate (11); or, the slot is disposed on a side of the base plate (11) facing the lateral beam.

4. The lifting platform according to claim 1, wherein the snap-fit (2) and the lateral beam are integrally arranged; or, the snap-fit (2) and the lateral beam are separately arranged.

5. The lifting platform according to claim 1, wherein the snap-fit (2) is arranged on a lateral side of the base plate (12); or, the snap-fit (2) is positioned on a side of the base plate (12) facing the lateral beam.

## Patentansprüche

1. Eine Hebebühne, umfassend: ein Oberteil, einen seitlichen Träger und eine Hubsäule, die unterhalb des Oberteils gelagert sind, Aktuatoren zum Antreiben des Hebens und Senkens der Hebebühne, und eine Steuerung, wobei die Hebebühne einen seitlichen Träger und Aktuatoren einschließt, wobei zwei Aktuatoren vorgesehen und jeweils an zwei Enden des seitlichen Trägers angeordnet sind, wobei:
die Steuerung einen Steuerkasten (1) und eine in dem Steuerkasten (1) vorgesehene Leiterplatte umfasst, wobei die Leiterplatte über Drähte mit den Aktuatoren verbunden ist, wobei die Rückseite des Steuerkastens mit dem seitlichen Träger verbunden ist, wobei Öffnungen (121), die die Verbindung zwischen dem Draht (4) und der Leiterplatte ermöglichen, an dem Steuerkasten (1) angeordnet sind, wobei mindestens eine Öffnung (121) an der Vorderseite des Steuerkastens (1) vorgesehen ist,
wobei der Steuerkasten (1) eine Grundplatte (11) und einen Kastenkörper (12) einschließt und der Steuerkasten (1) über die Grundplatte (11) auf den seitlichen Träger aufgesteckt wird, wobei eine Schnappverbindung (2) an dem seitlichen Träger vorgesehen ist und ein zu der Schnappverbindung (2) passender Schlitz an der Grundplatte (11) vorgesehen ist, wobei der Schlitz an dem seitlichen Träger angeordnet ist und eine zu dem Schlitz passende Schnappverbindung (2) an der Grundplatte (11) angeordnet ist.

2. Hebebühne nach Anspruch 1, wobei auf der Leiterplatte Anschlüsse zum Verbinden mit den Drähten vorgesehen sind, wobei die Anschlüsse durch die Öffnungen (121) freigelegt sind.

3. Hebebühne nach Anspruch 1, wobei der Schlitz auf einer lateralen Seite der Grundplatte (11) angeordnet ist, oder der Schlitz auf einer dem seitlichen Träger zugewandten Seite der Grundplatte (11) angeordnet ist.

4. Hebebühne nach Anspruch 1, wobei die Schnappverbindung (2) und der seitliche Träger einstückig angeordnet sind, oder die Schnappverbindung (2) und der seitliche Träger separat angeordnet sind.

5. Hebebühne nach Anspruch 1, wobei die Schnappverbindung (2) auf einer lateralen Seite der Grundplatte (12) angeordnet ist, oder die Schnappverbindung (2) auf einer dem seitlichen Träger zugewandten Seite der Grundplatte (12) angeordnet ist.

## Revendications

1. Plate-forme de levage, comprenant : une partie supérieure, une poutre latérale et une colonne de levage, qui sont supportées sous la partie supérieure, des actionneurs pour actionner le levage et l'abaissement de la plate-forme de levage, et un dispositif de commande, la plate-forme de levage incluant une poutre latérale et des actionneurs, deux actionneurs étant présents et respectivement disposés sur deux extrémités de la poutre latérale, dans laquelle :
le dispositif de commande comprend un boîtier de commande (1) et une carte de circuit imprimé disposée dans le boîtier de commande (1), la carte de circuit imprimé étant connectée aux actionneurs par l'intermédiaire de fils, l'arrière du boîtier de commande étant connecté à la poutre latérale, dans laquelle des ouvertures (121) facilitant la connexion entre le fil (4) et la carte de circuit imprimé sont agencées sur le boîtier de commande (1), au moins une ouverture (121) étant disposée à l'avant du boîtier de commande (1),
dans laquelle le boîtier de commande (1) comprend une plaque de base (11) et un corps de boîtier (12), et le boîtier de commande (1) est installé par insertion sur la poutre latérale via la plaque de base (11), dans laquelle un élément encliquetable (2) est disposé sur la poutre latérale, et une fente équipée de l'élément encliquetable (2) est disposée sur la plaque de base (11), dans laquelle la fente est agencée sur la poutre latérale, et un élément encliquetable (2) équipé de la fente est agencé sur la plaque de base (11).

2. Plate-forme de levage selon la revendication 1, dans laquelle des bornes à connecter aux fils sont disposées sur la carte de circuit imprimé, les bornes étant visibles par les ouvertures (121).

3. Plate-forme de levage selon la revendication 1, dans laquelle la fente est positionnée sur un côté latéral de la plaque de base (11) ; ou, la fente est disposée sur un côté de la plaque de base (11) faisant face à la poutre latérale.

4. Plate-forme de levage selon la revendication 1, dans laquelle l'élément encliquetable (2) et la poutre latérale sont agencés solidaires l'un de l'autre ; ou, l'élément encliquetable (2) et la poutre latérale sont agencés séparément.

5. Plate-forme de levage selon la revendication 1, dans laquelle l'élément encliquetable (2) est agencé sur un côté latéral de la plaque de base (12) ; ou, l'élément encliquetable (2) est positionné sur un côté de la plaque de base (12) faisant face à la poutre latérale.
